# EUROPÄISCHE PATENTSCHRIFT

(11) **EP 1 466 264 B1**
(45) Veröffentlichungstag und Bekanntmachung des Hinweises auf die Patenterteilung: **14.09.2011**
(21) Anmeldenummer: 02777144.3
(22) Anmeldetag: 18.09.2002
(51) Int. Cl.: G06F 15/78, G06F 17/50

(54) **VERFAHREN ZUR KONFIGURATION DER VERBINDUNG ZWISCHEN DATENVERARBEITUNGSZELLEN**
METHOD FOR CONFIGURATION OF THE CONNECTION BETWEEN DATA PROCESSING CELLS
PROCEDE POUR LA CONFIGURATION DES CONNEXIONS ENTRE DES CELLULES PROCESSEURS DE DONNEES

(30) Priorität: 19.09.2001 DE 10146132; 28.09.2001 US 967497; 30.09.2001 WO PCT/EP01/11299; 08.10.2001 WO PCT/EP01/11593; 05.11.2001 DE 10154259; 14.12.2001 EP 01129923; 18.01.2002 EP 02001331; 15.02.2002 DE 10206653; 18.02.2002 DE 10206857; 18.02.2002 DE 10206856; 21.02.2002 DE 10207224; 21.02.2002 DE 10207226; 27.02.2002 DE 10208435; 27.02.2002 DE 10208434; 05.03.2002 WO PCT/EP02/02402; 05.03.2002 WO PCT/EP02/02403; 05.03.2002 WO PCT/EP02/02398; 21.03.2002 DE 10212622; 21.03.2002 DE 10212621; 02.05.2002 DE 10219681; 02.05.2002 EP 02009868; 12.06.2002 DE 10226186; 20.06.2002 DE 10227650; 07.08.2002 DE 10236271; 21.08.2002 DE 10238174; 27.08.2002 DE 10240022; 27.08.2002 DE 10240000; 03.09.2002 DE 2003278; 09.09.2002 EP 02010084
(43) Veröffentlichungstag der Anmeldung: 13.10.2004
(73) Patentinhaber: Richter, Thomas, 04703 Bockelwitz (DE); Krass, Maren, 8044 Zürich (CH)
(72) Erfinder: VORBACH, Martin, 80689 München (DE); BRETZ, Daniel, 82008 Unterhaching (DE)
(74) Vertreter: Pietruk, Claus Peter
(86) Internationale Anmeldenummer: PCT/EP2002/010479
(87) Internationale Veröffentlichungsnummer: WO 2003/025781

(56) Entgegenhaltungen:
- WO-A-99/44120
- WO-A-99/44120
- US-A- 5 065 308
- US-A- 5 065 308
- FINEBERG S A ET AL: "EXPERIMENTAL ANALYSIS OF A MIXED-MODE PARALLEL ARCHITECTURE USING BITONIC SEQUENCE SORTING" JOURNAL OF PARALLEL AND DISTRIBUTED COMPUTING, ELSEVIER, AMSTERDAM, NL, Bd. 11, Nr. 3, 1. März 1991 (1991-03-01), Seiten 239-251, XP000201903 ISSN: 0743-7315
- RAMAN S ET AL: "Timing-constrained FPGA placement: a force-directed formulation and its performance evaluation" VLSI DESIGN GORDON & BREACH SWITZERLAND, Bd. 4, Nr. 4, 1996, Seiten 345-355, XP002481501 ISSN: 1065-514X
- YIH-CHIH CHOU ET AL: "A performance-driven standard-cell placer based on a modified force-directed algorithm" PROCEEDINGS OF ISPD'01. 2001 INTERNATIONAL SYMPOSIUM ON PHYSICAL DESIGN ACM NEW YORK, NY, USA, April 2001 (2001-04), Seiten 24-29, XP002481502 ISBN: 1-58113-347-2
- SHI JIANZHONG ET AL: "Performance driven floorplanning for FPGA based designs" ACM SIGDA INT SYMP FIELD PROGRAM GATE ARRAYS; ACM/SIGDA INTERNATIONAL SYMPOSIUM ON FIELD PROGRAMMABLE GATE ARRAYS - FPGA 1997 ACM, NEW YORK, NY, USA, 1997, Seiten 112-118, XP002481623
- KRUPNOVA H ET AL: "Synthesis and floorplanning for large hierarchical FPGAs" ACM SIGDA INT SYMP FIELD PROGRAM GATE ARRAYS; ACM/SIGDA INTERNATIONAL SYMPOSIUM ON FIELD PROGRAMMABLE GATE ARRAYS - FPGA 1997 ACM, NEW YORK, NY, USA, 1997, Seiten 105-111, XP002481624
- FINEBERG S A ET AL: "EXPERIMENTAL ANALYSIS OF A MIXED-MODE PARALLEL ARCHITECTURE USING BITONIC SEQUENCE SORTING" JOURNAL OF PARALLEL AND DISTRIBUTED COMPUTING, ACADEMIC PRESS, DULUTH, MN, US, vol. 11, no. 3, 1 March 1991 (1991-03-01), pages 239-251, XP000201903 ISSN: 0743-7315

## Beschreibung

Die Erfindung betrifft das oberbegrifflich Beanspruchte und befaßt sich somit mit konfigurierbaren Bausteinen und dergleichen und hier insbesondere mit dem Verwalten der Datenströme in diesen insbesondere dem Plazieren von Ressourcen und dem Routing von Verbindungen zwischen Zellen usw..

Es sind bereits multidimensionale Felder aus datenverarbeitenden Zellen bekannt. Zur Gattung dieser Bausteine zählen insbesondere systolische Arrays, neuronale Netze, Mehrprozessor Systeme, Prozessoren mit mehreren Rechenwerken und/oder logischen Zellen und/oder kommunikativen/peripheren Zellen (IO), Vernetzungs- und Netzwerkbausteine wie z.B. Crossbar-Schalter, ebenso wie bekannte Bausteine der Gattung FPGA, DPGA, Chameleon, XPUTER, etc.. Es sind insbesondere Bausteine bekannt, bei denen erste Zellen während der Laufzeit ohne Störung des Betriebes weiterer Zellen umkonfigurierbar sind, vgl. etwa die folgenden Schutzrechte und Anmeldungen desselben Anmelders: DE 44 16 881 A1, WO 98/26356, WO 98/28697, DE 196 54 846 A1, DE 196 54 593 A1, DE 197 04 044 A1, WO 98/35299, DE 198 61 088 A1, WO 99/44147, WO 00/77652, DE 100 36 627 A1, DE 100 28 397 A1, EP 1 454 258 A2, WO 02/071249, WO 02/29600. Hingewiesen wird weiter auf die Chameleon-Systems-Prozessor-Architektur. Die Brauchbarkeit der letztgenannten Konstruktion zu Datenverarbeitungszwecken ist jedoch eher vergleichbar mit einer Anordnung gemäß DE 101 03 624 A1.

Die datenverarbeitenden Zellen dieser Bausteine können nun unterschiedlichen Funktionen ausführen, etwa Bool 'sche und/oder arithmetisch Verknüpfungen von Eingangs-Operanden bewirken. Zwischen den Zellen verlaufen Verbindungen, die gleichfalls einstellbar sind, typisch etwa Busse, die auf verschiedene Weise eine Vernetzung bewirken können und so ein in seiner Vernetzung einstellbares multidimensionales Feld aufbauen. Über die Busse oder anderen Leitungen tauschen die Zellen miteinander wie erforderlich Informationen aus, etwa Statussignale, Trigger oder die zu verarbeitenden Daten. Typisch sind dabei in einem zweidimensionalen Prozessorfeld etwa die Zellen Reihen- und spaltenweise angeordnet, wobei die Ausgänge von Zellen einer ersten Reihe auf Busse geführt, an die zugleich die Eingänge der Zellen der nächsten Reihe zu koppeln sind. Bei einer bekannten Anordnung (Pact XPP) sind zudem Vorwärts- und Rückwärtsregister vorgesehen, um Daten unter Umgehung von Zellen auf Bussysteme anderer Reihen zu leiten, ein Balancing von parallel auszuführenden Zweigen zu erreichen, usw. Es ist auch schon vorgeschlagen worden, derartige Vor- und/oder Rückwärtsregister mit einer über den reinen Datentransfer hinausgehenden Funktionalität zu versehen.

Allgemein muß aber festgelegt werden, welche Zelle welche Datenverarbeitungsschritte durchführt, wo diese Zelle liegt und wie sie verbunden wird. Nach dem Stand der Technik sind bereits Strategien zur automatischen Steuerung von Plazierungs- und Routingmechanismen bekannt. Verwiesen wird insbesondere auf den Aufsatz *"*PERFORMANCE DRIVEN FLOORPLANNING FOR FPGA BASED DESIGNS" von J. Shi und D. Bhatia, ACM/SIGDA Interna-tional Symposium on Field Programmable Gate Arrays - FPGA 1997 ACM, New York, NY, USA, 1997. Weiter wird verweisen auf den Aufsatz *"*SYNTHESIS AND FLOORPLANNING FOR LARGE HIERARCHI-CAL FPGAs" von H. Krupnova et al., ACM/SIGDA Interna-tional Symposium on Field Programmable Gate Arrays - FPGA 1997 ACM, New York, NY, USA, 1997.

Typischerweise arbeiten etwa Placer nach einem Kräfteverfahren, das Kräfte zwischen Zellen zur optimalen Plazierung abhängiger Zellen verwendet, indem Verbindungen durch Federn in einem physikalischen Modell simuliert werden. Dadurch entsteht in der Regel ein zumeist geeignetes Plazierungsergebnis.

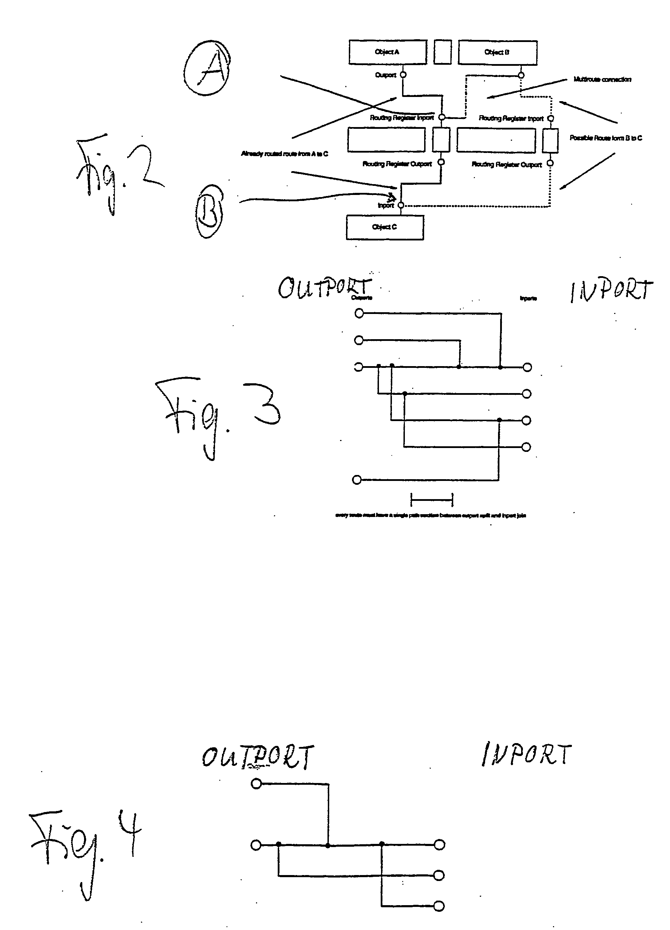

Weiterhin sind aus 44 16 881, DE 196 54 846.2, DE 102 06 653.1 Datenverarbeitungsverfahren für umkonfigurierbare Bausteine bekannt, bei welchen die Daten in jedem Verarbeitungsschritt von einem oder mehreren Speichern gelesen werden, verarbeitet werden und in einen oder mehrere Speicher geschrieben werden. Nach dem Stand der Technik sind die Schreib- und Lesespeicher unterschiedlich und typischerweise gegenüberliegend plaziert. (Figur xxua, xxub, xxuc, sowie vgl. DE 102 06 653.1 Figur 3).

Ebenfalls bekannt sind aus DE 197 04 728.9, DE 199 26 538.0, DE 100 28 397.7 spezielle Rekonfigurationsverfahren (Wave-Reconfiguration) für die genannten Bausteine bekannt, die eine besonders effiziente Rekonfiguration dadurch ermöglichen, dass die Rekonfigurationsinformation mit den letzten zu verarbeitenden Daten über die Daten- und/oder Triggerbusse mit-übertragen wird und direkt nach erfolgter Verarbeitung die Busse und Zellen neu konfiguriert werden.

Um eine bestimmte Art der Datenverarbeitung durchzuführen, muß jeder Zelle eine bestimmte Funktion zugewiesen werden und es ist zugleich eine geeignete räumliche Lage und Vernetzung vorzusehen. Es muß dazu, bevor das multidimensionale Prozessorfeld Daten wie gewünscht verarbeitet, also festgelegt werden, welche Zelle welche Funktion ausführen soll, wobei für jede an einer Datenverarbeitungsaufgabe beteiligte Zelle eine Funktion festzulegen ist und es muß die Vernetzung bestimmt werden.

Es ist wünschenswert, Konfigurationen von multidimensionalen Feldern rekonfigurierbarer Zellen so zu bestimmen, dass die Datenverarbeitung verbessert wird.

Die Lösung der Aufgabe wird unabhängig im Anspruch 1 beansprucht.

Beschrieben wird dabei zunächst ein Verfahren zur Erzeugung von Konfigurationen für multidimensionale Felder rekonfigurierbarer Zellen zur Durchführung vorgegebener Anwendungen, bei dem eine Anwendung in Einzelmodule zerlegt und eine modulweise Plazierung der zur Durchführung erforderlichen Elemente vorgenommen wird. Eine solche Modulzerlegung ist vorteilhaft, weil dann für diese Module einfacher Konfigurationen bestimmt werden können.

Besonders bevorzugt ist es, wenn bei dem Verfahren, wenn zumindest in einem Modul ortsfeste Elemente vorhanden sind, diese an vorgegebenen Stellen vorgesehen werden und die nichtfesten Elemente nachfolgend plaziert werden. Es ist dann möglich, daß die modulweise Plazierung durch Minimierung zugewiesener virtueller Kräfte unter den einzelnen beweglichen und/oder unbeweglichen Objekten erfolgt.

In der Regel ist es auch wünschenswert, die Funktion und Vernetzung so anzuordnen, daß die Datenverarbeitung möglichst zügig und/oder ressourcenschonend erfolgen kann. Oftmals ist es jedoch, etwa aufgrund von Hardware-Beschränkungen, nicht möglich, eine Anordnung zu finden, die den gewünschten Datentransfer in optimaler Weise gewährleistet. Es müssen dann suboptimale Anordnungen verwendet werden.

Es wird nun erfindungsgemäß weiter vorgeschlagen, zur Verbesserung der Konfiguration für multidimensionale Felder rekonfigurierbar vernetzter Datenverarbeitungszellen, dass benötigte Verbindungen zwischen Zellen priorisiert, dann zunächst Verbindungen, die eine hohe Priorität besitzen und nachfolgend weitere Verbindungen vorgesehen werden.

Auf diese Weise wird die Verwendung suboptimaler Anordnungen schon dadurch minimiert, daß sichergestellt ist, daß über etwa aufgrund einer benötigten hohen geringen Latenzzeit etc. besonders wichtige Verbindungen Daten mit geringeren Beschränkungen durch Ressourcenknappheit wie eine beschränkte Buszahl etc. strömen können.

Es ist daher auch bevorzugt möglich, daß Verbindungen gerade unter Berücksichtigung einer zulässigen Verzögerung bei der Datenverarbeitung priorisiert werden. Die Priorisierung kann unter Berücksichtigung der maximal zulässigen Verzögerung und/oder der Verzögerungsverhältnisse unterschiedlicher Verbindungen vorgenommen werden. Als Verzögerungsverhältnisse ist bei der Priorisierung bevorzugt eine Verzögerung "O", "länger als", "länger als oder gleich zu " und "gleich zu" berücksichtigen.

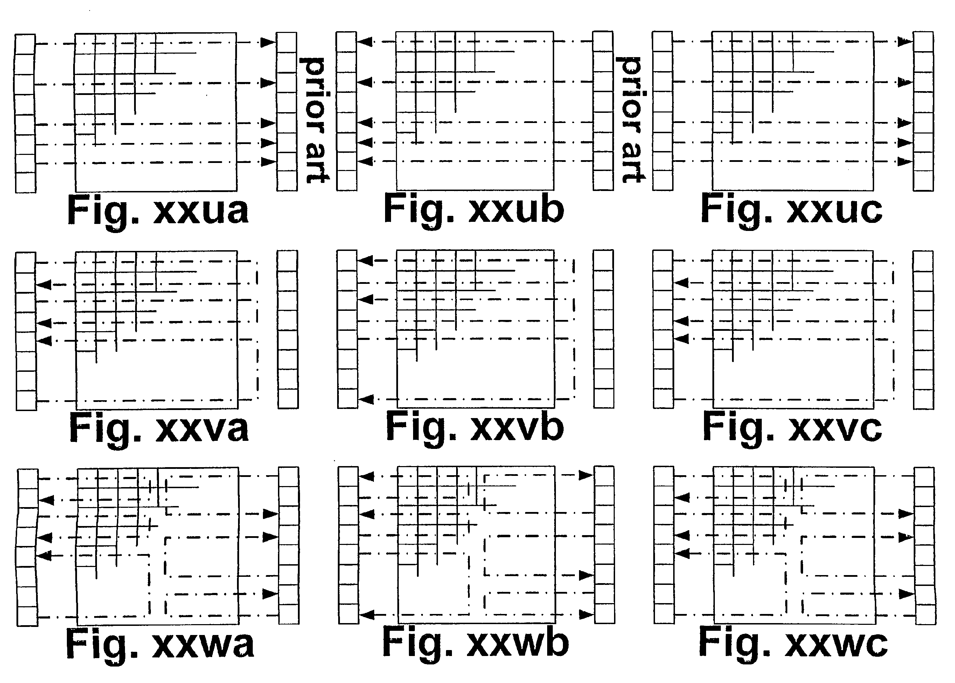

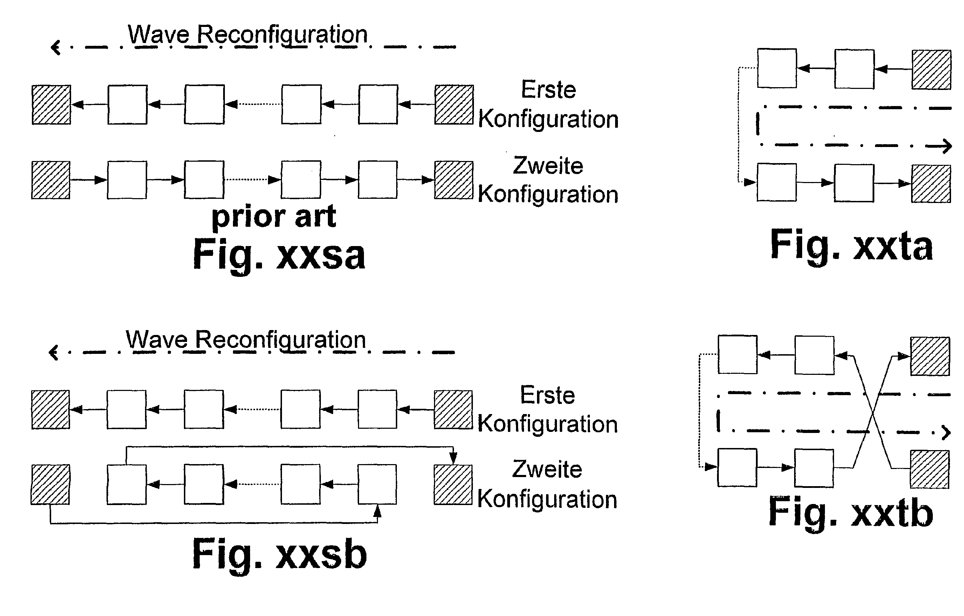

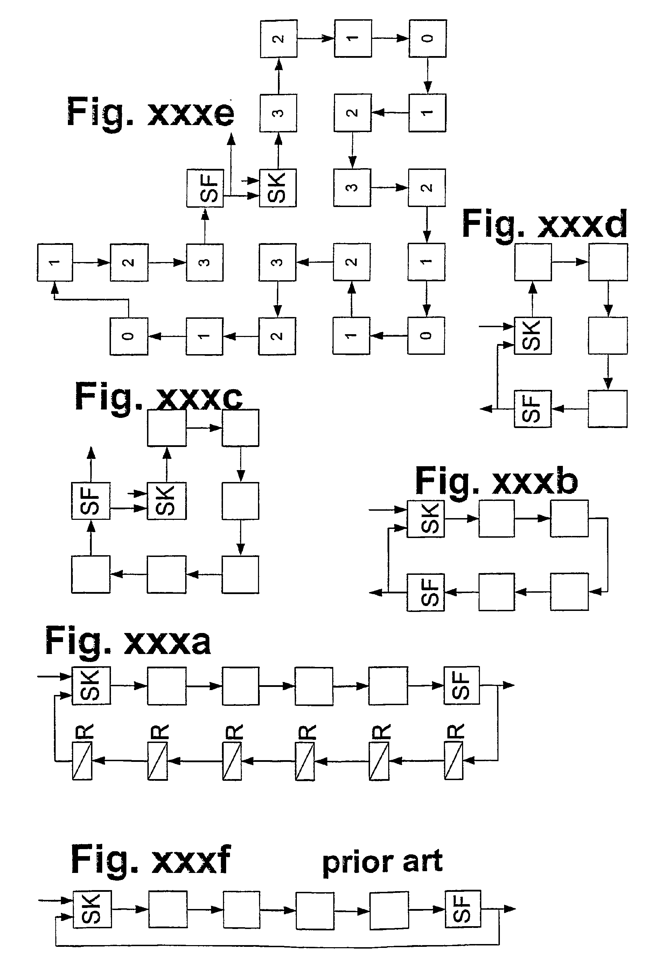

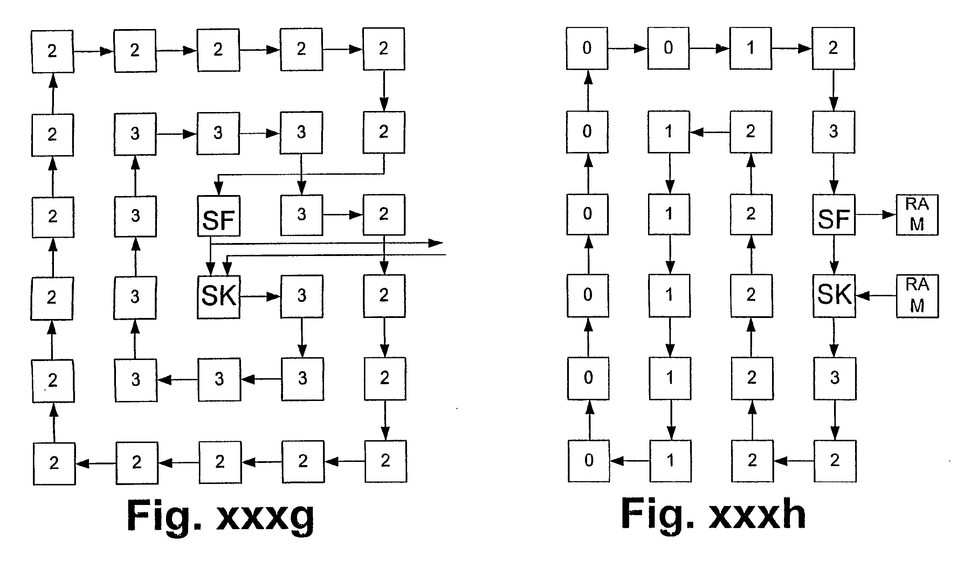

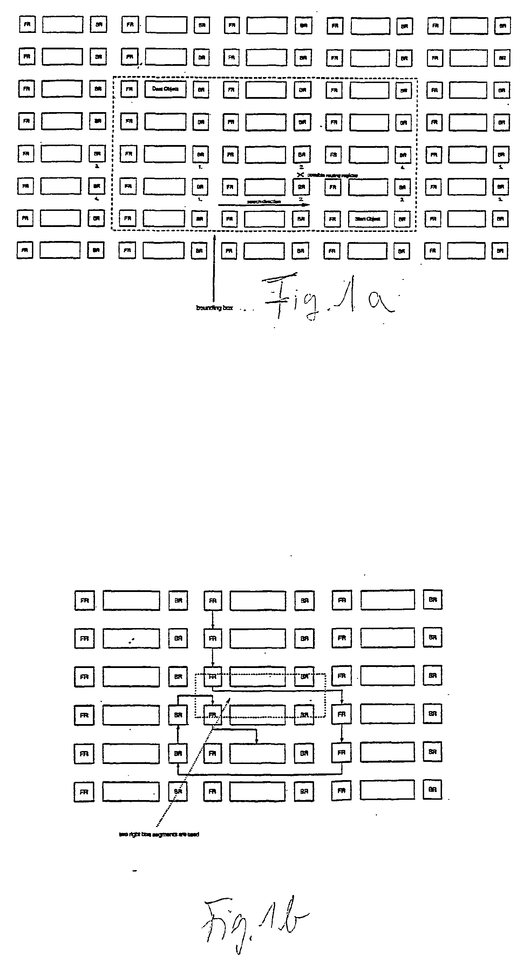

Die Verbindungen zwischen den Zellen einer Konfiguration werden dabei etwa so erzeugt, daß eine Zellumgrenzung definiert und zunächst versucht wird, die Zellen über Verbindungen innerhalb der Umgrenzung zu verbinden. Dies wird mit Bezug auf die Fig. 1a und b gezeigt, wo für eine XPP-Architektur des Anmelders die PAE-Zellen langgestreckt und von als "FR" und "BR" bezeichneten Vorwärts- bzw. Rückwärts-Registern flankiert dargestellt sind. Ein Feldteil ist von einer gestrichelten Linie umgrenzt, die die Umgrenzung darstellt. Typisch wird bei einem Routeversuch erst in X-Richtung, also horizontal von Start- zu Zielzelle fortgeschritten und dann, sofern in einer Reihe in X-Richtung kein Fortkommen mehr möglich ist, etwa weil keine geeigneten Busse mehr verfügbar sind, wird die Reihe in y-Richtung gewechselt. Fig. 1b zeigt dabei ein Beispiel für eine mögliche Verbindungsleitung, wenn zwischen gegebenen Zellen keine unmittelbare Verbindung mehr möglich ist.

Es ist möglich, daß dann, wenn nicht alle erforderlichen Verbindungen innerhalb der Umgrenzung vorgesehen werden können, eine Verbindung außerhalb der Umgebung vorgesehen wird. Dann, wenn eine weitere Verbindung nicht wie erforderlich gelegt werden kann, soll in beiden Fällen, also inner- oder außerhalb, eine bereits vorgesehene Verbindung getrennt und die weitere Verbindung vorgesehen wird, worauf versucht wird, eienn Ersatz für die getrennte Verbindung vorzusehen. Bevorzugt wird jedoch mit dem Überschreiten der Umgrenzung solange zugewartet, bis feststeht, daß auch durch Auftrennung keine Verbindungen zusätzlich innerhalb der Umgrenzung legbar sind.

Es ist möglich, daß Verbindungen vorgesehen werden, auf welchen sich eine Vielzahl von Ausgängen sammeln und die mit einer Vielzahl von Eingängen verbunden sind, wobei eine Verbindung so vorgesehen wird, dass ein Wegstück die Eingangssammelpunkte und die Ausgangsgabelungen trennt. Dies ist in den Figuren 2 bis 4 veranschaulicht, die zeigen, wie zulässige und unzulässige Verbindungen aussehen können. Fig. 2 zeigt dabei allgemein, wie Daten aus einem Outputport, d.h. einem Ausgangsanschluß an einem Sammelpunkt zusammenlaufen, Pfeil "A" und wie dies an einem Eingang einer Zelle geschehen kann, Pfeil "B". Damit zeigt Fig 2 Möglichkeiten für untershciedliche Pfade, längs welcher Daten aus dem Objekt B (Zelle) rechts oben zu dem untern Objekt laufen können. Bei dem unteren Objekt kann es sich z.B. um eine PAE, eine IOPAE usw. handeln. Die Fig. 3 und 4 zeigen, wie an Knotenpunkten Daten in erlaubter Weise zusammenlaufen (Fig. 3), weil dort zwischen jeder Route ein einzelner Pfadabschnitt zwischen Ausgangsgabelungen (Outportsplits) und Eingangsverbindungen (Inportjoins) vorgesehen ist.

Es ist bevorzugt, wenn nach dem Legen der Verbindungen die maximale Latenzzeit der Konfiguration bestimmt und/oder eine dieser entsprechende Maximalfrequenz für den Konfigurationsbetrieb ermittelt wird. Diese Information kann zur Bewertung der Qualität des Konfigurationsergebnisses und/oder zur Datenverarbeitung mit der Konfiguration verwendet werden.

Bevorzugt wird auch, wenn nach Festlegung aller Signallaufwege längs aller Verbindungen ein Laufzeitausgleich für an Knoten zusammenlaufende Signale vorgenommen wird. Dies ist in der XPP-Technologie des Anmelders, für die die vorliegende Anmeldung besonders bevorzugt ist, durch das Vorsehen von Registerstufen möglich, die in die Verbindungswege, insbesondere bei Veränderung der Zellreihe, eingesetzt werden können. Es kann dabei zunächst eine Verbindung mit Register vorgesehen werden und es wird dann die zum sog. Balancing erforderliche Registerzahl bestimmt. Dieses Vorgehen bei der Plazierung und beim Routen ist besonders vorteilhaft.

Im Stand der Technik besteht nun weiter gelegentlich ein Problem, dessen wenigstens partielle Linderung in bestimmten Situationen von Vorteil wäre. Es ist nämlich oftmals die automatisch erstellte Plazierung für Rückkopplungen, also zum Beispiel für Programmschleifen, bei denen Daten von einer datenstromabwärtigen Zelle zu einer Daten zuvor bearbeitet habenden Zelle zumeist dahingehend ineffizient, dass die Rückkopplung zu weit, also der Rückkopplungsbus zu lang ist (Figur xxxf). Mit anderen Worten sind Sender und Empfänger einer Rückkopplung zu weit voneinander entfernt. Dies senkt die Verarbeitungsfrequenz rekonfigurierbarer Bausteine erheblich.

Wünschenswert ist es nun, eine Möglichkeit zu schaffen, die Anordnung und/oder Vernetzung der Zellen und/oder zellenenthaltender Bausteine zu verbessern.

Ein erster erfindungsgemäßer Ansatz schafft hier Abhilfe, indem in die langen Rückkopplungsbusse in regelmäßigen Abständen Register (R) eingeführt werden (Figur xxxa), wodurch eine Art Pipelining entsteht und die Taktfrequenz entsprechend steigt, da die Übertragungszeiten zwischen den Registern deutlich kürzer ist als die Übertragungszeit direkt vom Sender zum Empfänger. Durch dieses Verfahren entsteht jedoch eine erhebliche Latenzzeit, die besonders bei Schleifen die Verarbeitungsleistung wiederum erheblich senkt.

Auch für die Wave-Reconfiguration ist es möglich, eine besonders leistungsfähige Datenverarbeitung vorzusehen, wenn nämlich direkt (also noch im selben oder einem kurz darauffolgenden Takt) nach Verarbeitung des letzten Datenwortes einer ersten Konfiguration eine zweite Rekonfiguration konfiguriert werden kann und direkt (also noch im selben oder einem kurz darauffolgenden Takt) danach das erste Datenwort der zweiten Konfiguration verarbeitet wird.

Nach Figur xxua - xxuc ändert sich jedoch die Datenflußrichtung jeder nacheinanderfolgenden Konfiguration. Damit kann zwar nach jeder Verarbeitung eines letzten Datenwortes sofort die nachfolgende Konfiguration eingestellt werden, aber erst nach Rekonfiguration aller beteiligten Zellen und Busse kann mit der nachfolgenden Datenverarbeitung begonnen werden (Figur xxsa). Ein erfindungsgemäßer Ansatz besteht nun darin, die Laufrichtung zwischen den Zellen weitestgehend beizubehalten und lediglich die Bussysteme der Speicher zu tauschen (Figur xxsb). Dadurch entsteht aber wiederum das vorstehend bei den Rückkopplungen beschriebene Problem der langen Laufzeiten und niederen Taktraten. Auch hier könnten, wie bereits beschrieben, Register eingeführt werden, was zu einer Taktfrequenzsteigerung führen würde. Gleichzeitig entsteht aber eine nicht unerhebliche Latenzzeit, was wiederum unerwünscht sein kann.

In einer bevorzugten Variante werden daher Register durchströmte Rückkopplungsschleifen vermieden.

Es hat sich gezeigt, dass besonders gute Lösungen erzielt werden können, wenn alle Zellen einer Schleife möglichst lokal um einen Schleifenkopf (SK) angeordnet werden und insbesondere der Schleifenfuss (SF) möglichst nahe an SK plaziert wird (Figur xxxb, xxxd). Ebenfalls optimal ist eine schneckenförmige Anordnung ähnlich dem Zeichen @ (Figur xxxc).

Es wird daher vorgeschlagen, zur Konfigurierung und/oder Rekonfigurierung eines multidimensionalen Feldes und/oder Zellen, für eine Datenverarbeitung, bei der Daten in Zellen verarbeitet, Verarbeitungsergebnisse an Zellen stromabwärts geleitet werden, um dort weiterverarbeitet zu werden, wobei wenigstens von einer Zelle stromabwärts Daten zu wenigstens einer Zelle stromaufwärts geführt werden, dass die Zellposition so bestimmt wird, dass die stromabwärtige so nahe an der stromaufwärtigen Zelle positioniert wird, daß die Rückkopplungszeit dieser Verbindung nicht größer ist als jene anderer Verbindungen in der Konfiguration.

Bevorzugt kann dies typisch dadurch erreicht werden, daß die stromabwärtige Zelle näher als ¼ des gesamten Datendurchströmten Weges bei der stromaufwärtigen Zelle angeordnet ist.

Dies läßt sich insbesondere gut erreichen, wenn die datendichtesten Zellen zwischen stromauf- und stromabwärtigem Ende wendel- und/oder mäanderartig angeordnet sind.

Es gibt nun verschiedene Möglichkeiten, eine solche Rückkopplungsschleifenminimierung zu erzielen.

So können Platzierungen unter Minimierung von virtuellen Kräften zwischen Zellen und anderen Objekten vorgenommen werde, wobei dann die Rückkopplungsschleifenminimierung etwa dadurch erreicht wird, dass eine weitere "virtuelle" Federkraft eingeführt wird, die von jedem Element einer Schleife zu dem Schleifenkopf (SK) und/oder dem Schleifenfuß (SF) führt. Alternativ und/oder zusätzlich kann eine virtuelle Kraft zwischen Schleifenfuß und Schleifenkopf vorgesehen werden. Diese virtuelle Federkraft repräsentiert dabei keine Busverbindung, sondern dient lediglich der Erzielung der erfindungsgemäß Plazierungsanordnung. Insbesondere kann die virtuelle Federkraft unterschiedlich zu der Federkraft von tatsächlich existierenden Busverbindungen sein. Weitere Verfahren zur automatischen Generierung der Plazierungsanordnung sind dem Fachmann entsprechend des jeweiligen Platziererprinzips dann offensichtlich.

Für sehr große Schleifen werden die Zellen der Schleife meanderförmig um die SK und/oder SF angeordnet (Figur xxxe) oder um SK und/oder SF gewickelt, wobei eine meanderförmige Anordnung bevorzugt wird.

Ein Wickel kann dadurch erzielt werden, dass die "virtuellen" Federkräfte linear oder gleichmäßig stufenweise über die Länge der Schleife hinweg abgebaut werden. Figur xxxg zeigt eine entsprechendes Beispiel, bei dem die Federkräfte stufenweise abgebaut wurden. Wickel weisen das Problem auf, dass relativ lange Busse zum Kern des Wickels (SK, SF) entstehen.

Die bevorzugte meanderförmige Anordnung kann erzielt werden, indem den jeweiligen Zellen der Schleife periodisch höhere und niedere "virtuelle" Federkräfte zu SK und/oder SF zugeordnet werden. Beispielsweise kann mittels einer Sinus- oder Quasisinusfunktion eine derartige Zuordnung erfolgen. In Figur xxxe sind beispielsweise solche periodischen "virtuellen" Federkräfte (0,1,2,3) eingetragen. Die Perioden, also die Frequenz der Sinusfunktion sollte dabei optimal so bestimmt werden, dass die jeweils erste Zelle nach SK und die letzte Zelle vor SF (oder SF selbst) eine möglichst maximale Federkraft aufweisen, um diese möglichst lokal beisammen zu platzieren. Durch die Platzierung unter Definition einer virtuellen Wickelkraft können unterschiedliche Aufgaben konfiguriert und/oder platziert werden.

Prinzipiell sind also Verfahren anwendbar, die vorsehen, dass in ein Feld mit Zellen wählbarer Funktion die Zellposition durch Minimierung von virtuellen Kräften den Zellen bestimmt werden, wobei von Null verschiedene virtuelle Kräfte zwischen stromauf- und stromabwärtiger Zelle (SF, SK) vorgesehen werden. Es kann insbesondere im Weg zwischen stromaufwärtiger und stromabwärtiger Zelle ein Speicher, insbesondere ein Multiport-Speicher vorgesehen werden.

So wird zur Optimierung der Wave-Rekonfiguration nunmehr ein entsprechendes Verfahren genutzt. Zunächst wird dabei etwa festgelegt, dass die Speicher zum Lesen von Daten und Schreiben von Daten nicht auf den gegenüberliegenden Seiten eines Arrays aus Zellen liegen, sondern entsprechend SK und SF möglichst direkt lokal beieinander liegen (Figur xxta). Bei der Durchführung einer Rekonfiguration brauchen nunmehr nur die Bussysteme zwischen den Schreib-/Lesespeichern getauscht werden. Die Busse werden dadurch nur, wenn überhaupt minimal länger, was jedoch zu keiner erheblichen Beeinträchtigung der Taktfrequenz führt (Figur xxtb). Eine weitere Optimierung kann dann dadurch erfolgen, dass zum Lesen der Daten (Operanden) und zum Schreiben der Ergebnisse dieselben Speicher benutzt werden, wobei allerdings z.B. unterschiedliche Speicherbänke oder unterschiedliche Schreib-/Lesezeiger bei FIFOartigen Speicher verwendet werden, und wobei bevorzugt Mehrport-Speicher zum Einsatz kommen, die zeitgleiche Zugriffe auf mehrere Ports ermöglichen. In einer solchen, bevorzugten Variante entfällt sogar die Vertauschung der Bussysteme, da ein und derselbe Speicher verwendet wird.

Unter Anwendung dieses Prinzips ändert sich die Datenlaufrichtung gegenüber der Wave-Rekonfigurationslaufrichtung nicht, wodurch eine optimale Performance erzielt wird.

Innerhalb eines Arrays können mehrere dieser Anordnungen gleichzeitig implementiert sein. In Figur xxva-xxvc ist dies für zwei Rekonfigurationszyklen beispielhaft dargestellt. Ebenfalls können entsprechende Anordnungen von mehreren Seiten des Arrays aus gleichzeitig benutzt werden. In Figur xxwa-xxwc sind zwei dementsprechende Rekonfigurationszyklen beispielhaft dargestellt.

Besonders leistungsfähig wird das Verfahren nach Figur xxx dann, wenn die Anforderungen der Wave-Rekonfiguration derart mitberücksichtigt werden, dass z.B. SK und/oder SF möglichst lokal zu einem Speicher (RAM) liegen sollen. Dies wird möglich, etwa indem die Schleife nur in 3 Richtungen ausgewalzt wird (Figur xxxh), was wiederum durch einen geeigneten periodischen Aufbau der "virtuellen" Federkräfte erreicht werden kann. Je nachdem ob die Federkräfte gleichmäßig auf- beziehungsweise abgebaut werden, können unterschiedliche Anordnungen erzielt werden. Das in Figur xxxh gezeigte Beispiel verwendet einen gleichmäßigen linearen langsamen Aufbau und einen schnellen linearen Abbau.

## Patentansprüche

1. Verfahren zur Erzeugung von Konfigurationen für multidimensionale Felder rekonfigurierbarer Zellen, die zur Durchführung vorgegebener Anwendungen wiederholt rekonfiguriert werden,
wobei
das multidimensionale Feld
Zellen,
denen eine bestimmte Funktion zugewiesen werden kann,
Speicher,
in die eine erste Konfiguration schreiben und aus denen eine zweite Konfiguration die von der ersten Konfiguration geschriebenen Daten lesen kann, und
Objekte zur Vernetzung der Zellen
umfasst
und wobei
zur Erzeugung jeweiliger Konfigurationen
eine automatische Platzierung und Verbindungsfestlegung dieser
bei der Anwendungsdurchführung benutzten Elemente
im Feld generiert wird,
wobei
die Anwendung in eine Vielzahl von Modulen zerlegt wird und
zur Bestimmung einer Konfiguration eine automatische Platzierung für jedes Modul einzeln erfolgt,
indem für wenigstens eines der Module
als festes Element
wenigstens einer der Speicher, in die eine erste Konfiguration schreiben und aus denen eine zweite Konfiguration die von der ersten Konfiguration geschriebenen Daten lesen kann,
zum Schreiben an einer Stelle platziert wird, an der auch in einer nachfolgenden Konfiguration ein Speicher zum Lesen platziert wird,
und
für wenigstens zwei Konfigurationen, in denen Schleifen abzuarbeiten sind,
Schleifenkopf (SK) und Schleifenfuß (SF) nahe dem Speicher angeordnet werden und danach
modulweise eine Platzierung der weiteren, zur Durchführung erforderlichen Elemente, insbesondere die zwischen Schleifenkopf und Schleifenfuß vorgesehenen Elemente, durch Minimierung zugewiesener virtueller Kräfte unter den einzelnen festen und/oder nichtfesten Elementen automatisch generiert wird,
um so zu ermöglichen, dass zum Schreiben der Daten und zum Lesen der Daten Schleifenkopf und Schleifenfuß dieselben Speicher verwenden.

## Claims

1. Method for producing configurations for multidimensional fields in reconfigurable cells which are repeatedly reconfigured in order to perform prescribed applications,
wherein
the multidimensional field comprises
cells
to which a particular function can be assigned, memories
to which a first configuration can write and from which a second configuration can read the data written by the first configuration, and
objects for networking the cells,
and wherein
respective configurations are produced by virtue of an automatic placement and connection stipulation for these
elements used for performing the application being generated in the field,
wherein
the application is broken down into a multiplicity of modules and
a configuration is determined by virtue of automatic placement being effected for each module individually by dint of at least one of the modules
as a fixed element
having at least one of the memories to which a first configuration can write and from which a second configuration can read the data written by the first configuration
placed, for the purpose of writing, at a location at which a memory is also placed, for the purpose of reading, in a subsequent configuration,
and
at least two configurations in which loops need to be executed
having the loop head (SK) and the loop foot (SF) arranged close to the memory and then
a placement for the further elements that are required for the performance, particularly the elements provided between the loop head and the loop foot, being automatically generated on a module-by-module basis by minimizing assigned virtual forces among the individual fixed and/or non-fixed elements,
so as to allow the loop head and the loop foot to use the same memories for writing the data and for reading the data.

## Revendications

1. Procédé de génération de configurations pour des cellules reconfigurables de champs multidimensionnels, lesquelles sont reconfigurées de manière répétée pour exécuter des applications prédéfinies,
dans lequel le champ multidimensionnel comprend des cellules auxquelles peut être attribuée une fonction donnée, des mémoires dans lesquelles peut être écrite une première configuration et depuis lesquelles peut être lue une deuxième configuration des données écrites par la première configuration, ainsi que des objets pour mettre les cellules en réseau
et dans lequel, pour générer les configurations respectives, un placement automatique et une définition de la liaison de ces éléments utilisés lors de l'exécution des applications sont générés dans le champ,
dans lequel l'application est décomposée en une pluralité de modules et, pour déterminer une configuration, un placement de chaque module individuel est effectué,
en ce que pour au moins l'un des modules, au moins l'une des mémoires dans lesquelles peut être écrite une première configuration et depuis lesquelles peut être lue une deuxième configuration des données écrites par la première configuration est placée en vue de l'écriture en tant qu'élément fixe en un endroit auquel est également placée une mémoire en vue de la lecture dans une configuration suivante,
et
pour au moins deux configurations dans lesquelles il faut traiter des boucles, la tête de boucle (SK) et la base de boucle (SF) sont disposées à proximité de la mémoire et un placement des autres éléments nécessaires à l'exécution est ensuite généré automatiquement module par module, notamment les éléments prévus entre la tête de boucle et la base de boucle, en réduisant les forces virtuelles attribuées sous les éléments fixes et/ou non fixes individuels afin de permettre ainsi que la tête de boucle et le base de boucle utilisent la même mémoire pour l'écriture des données et pour la lecture des données.
